# EUROPEAN PATENT APPLICATION

(11) **EP 4 580 366 A1**
(43) Date of publication of application: **02.07.2025**
(21) Application number: 24220817.1
(22) Date of filing: 17.12.2024
(51) Int. Cl.: H10K 59/122, H10K 59/131, H10K 59/80

(54) **DISPLAY APPARATUS AND ELECTRONIC APPARATUS INCLUDING THE SAME**

(30) Priority: 29.12.2023 KR 20230197606
(71) Applicant: Samsung Display Co., Ltd., Yongin-si, Gyeonggi-do 17113 (KR)
(72) Inventor: Lim, Dogi, 17113 Yongin-si, Gyeonggi-do (KR); Cho, Youngje, 17113 Yongin-si, Gyeonggi-do (KR); Kim, Yuloh, 17113 Yongin-si, Gyeonggi-do (KR); Kim, Ilhoon, 17113 Yongin-si, Gyeonggi-do (KR); Lee, Seongyoung, 17113 Yongin-si, Gyeonggi-do (KR)
(74) Representative: Gulde & Partner

(57) **Abstract**

A display apparatus includes a substrate including a display area and a peripheral area outside the display area. A common voltage supply line is located in the peripheral area. A protective conductive layer directly contacts the common voltage supply line. A common electrode extends from the display area to the peripheral area and directly contacts the protective conductive layer. An end of the common electrode adjacent to an edge of the substrate is closer to the edge of the substrate than an end of the protective conductive layer adjacent to the edge of the substrate.

## Description

### 1. Technical Field

One or more embodiments relate to a display apparatus and an electronic apparatus including the same, and more particularly, to a display apparatus that may prevent or reduce defects from occurring during a manufacturing process and an electronic apparatus including the display apparatus.

### 2. Discussion of Related Art

In general, a display apparatus includes a plurality of display devices located in a display area. Each of the plurality of display devices may include a pixel electrode and a counter electrode. The counter electrode may be integrally formed in the plurality of display devices. The integrally formed counter electrode may be referred to as a common electrode.

A conventional display apparatus and an electronic apparatus including the display apparatus may experience defects, such as a dielectric breakdown in some insulating layers, which occur during a manufacturing process.

### SUMMARY

One or more embodiments include a display apparatus that may prevent or reduce defects from occurring during a manufacturing process and an electronic apparatus including the display apparatus. However, embodiments of the present disclosure are examples and do not limit the scope of the present disclosure.

Additional aspects will be set forth in part in the description which follows and, in part, will be apparent from the description, or may be learned by practice of the presented embodiments.

According to an embodiment of the present disclosure, a display apparatus includes a substrate including a display area and a peripheral area outside the display area. A common voltage supply line is located in the peripheral area. A protective conductive layer directly contacts the common voltage supply line. A common electrode extends from the display area to the peripheral area and directly contacts the protective conductive layer. An end of the common electrode adjacent to an edge of the substrate is closer to the edge of the substrate than an end of the protective conductive layer adjacent to the edge of the substrate. The edge of the substrate may be disposed away from the display area.

In an embodiment, the protective conductive layer may directly contact a top surface of the common voltage supply line.

In an embodiment, the display apparatus may further include a first insulating layer covering the common voltage supply line. The first insulating layer may include a first opening exposing a portion of the top surface of the common voltage supply line. The protective conductive layer may be disposed on the first insulating layer and directly contacts the common voltage supply line through the first opening.

In an embodiment, the common electrode may directly contact a top surface of the protective conductive layer.

In an embodiment, the end of the protective conductive may be disposed on a top surface of the first insulating layer.

In an embodiment, the display apparatus may further include a second insulating layer covering the protective conductive layer. The second insulating layer may include a second opening exposing a portion of a top surface of the protective conductive layer. The common electrode may be disposed on the second insulating layer and directly contacts the protective conductive layer through the second opening. The common electrode may over an entirety of the portion of the top surface of the protective conductive layer exposed through the second opening. A width of the second opening may be greater than a width of the first opening.

In an embodiment, the end of the common electrode may be disposed on a top surface of the second insulating layer.

In an embodiment, the end of the common electrode may be closer to the edge of the substrate than an end of a portion of the top surface of the common voltage supply line adjacent to the edge of the substrate that is exposed through the first opening.

In an embodiment, the display apparatus may further include a protective insulating layer interposed between the common voltage supply line and the first insulating layer. The protective insulating layer may include an additional opening exposing a portion of the top surface of the common voltage supply line. When viewed in a direction perpendicular to the substrate, the end of the common electrode may coincide with an end of the portion of the top surface of the common voltage supply line that is exposed through the additional opening.

In an embodiment, an area of the additional opening in a plan view may be greater than an area of the first opening in the plan view.

In an embodiment, when viewed in the direction perpendicular to the substrate, the first opening may be inside the additional opening.

In an embodiment, the display apparatus may further include a pixel electrode located in the display area, wherein the protective conductive layer and the pixel electrode include a same material as each other.

In an embodiment, each of the protective conductive layer and the pixel electrode may include a transparent conductive layer.

In an embodiment, the pixel electrode and the protective conductive layer may be disposed on a same layer as each other.

In an embodiment, a distance between the end of the common electrode and the end of the protective conductive layer may be in a range of about 300 µm to about 1000 µm.

In an embodiment, the display apparatus may further include a dam located in the peripheral area and surrounding the display area. An inorganic encapsulation layer may be disposed on the common electrode and extending outward from the common electrode to the dam.

According to an embodiment of the present disclosure, a display apparatus includes a substrate including a display area and a peripheral area outside the display area. A common voltage supply line is located in the peripheral area. A protective conductive layer directly contacts the common voltage supply line. A common electrode extends from the display area to the peripheral area and directly contacts the protective conductive layer. When viewed in a direction perpendicular to the substrate, an area of a portion of the common electrode overlapping the common voltage supply line is greater than an area of a portion of the protective conductive layer overlapping the common voltage supply line.

In an embodiment, an end of the common voltage supply line adjacent to an edge of the substrate may be closer to the edge of the substrate than an end of the protective conductive layer adjacent to the edge of the substrate.

In an embodiment, the protective conductive layer may directly contact a top surface of the common voltage supply line.

In an embodiment, the display apparatus may further include a first insulating layer covering the common voltage supply line and including a first opening exposing a portion of the top surface of the common voltage supply line. The protective conductive layer is disposed on the first insulating layer and directly contacts the common voltage supply line through the first opening.

In an embodiment, the common electrode may directly contact a top surface of the protective conductive layer.

In an embodiment, an end of the protective conductive layer adjacent to an edge of the substrate may be disposed on a top surface of the first insulating layer.

In an embodiment, the display apparatus may further include a second insulating layer covering the protective conductive layer. The second insulating layer includes a second opening exposing a portion of a top surface of the protective conductive layer. The common electrode is disposed on the second insulating layer and directly contacts the protective conductive layer through the second opening.

In an embodiment, an end of the common electrode adjacent to the edge of the substrate may be disposed on a top surface of the second insulating layer.

According to an embodiment of the present disclosure, a display apparatus includes a substrate comprising a display area and a peripheral area outside the display area. A common voltage supply line is located in the peripheral area. A first insulating layer covers the common voltage supply line. The first insulating layer comprises a first opening exposing a portion of a top surface of the common voltage supply line. A protective conductive layer covers an entirety of the portion of the top surface of the common voltage supply line exposed by the first opening. A second insulating layer covers the protective conductive layer. The second insulating layer comprises a second opening exposing a portion of a top surface of the protective conductive layer. A common electrode extends from the display area to the peripheral area and covers an entirety of the portion of the top surface of the protective conductive layer exposed by the second opening. The protective conductive layer electrically connects the common voltage supply line to the common electrode. An end of the common electrode adjacent to an edge of the substrate is closer to the edge of the substrate than an end of the protective conductive layer adjacent to the edge of the substrate.

In an embodiment, a distance between the end of the common electrode and the end of the protective conductive layer is in a range of about 300 µm to about 1000 µm.

In an embodiment, the end of the protective conductive layer is disposed directly on an upper surface of the first insulating layer. The end of the common electrode is disposed directly on an upper surface of the second insulating layer.

According to an embodiment of the present disclosure, an electronic apparatus includes one of the display apparatuses described above.

In an embodiment, the electronic apparatus may be at least one of a smartphone, a mobile phone, a smart watch, a navigation device, a game device, a television (TV), a vehicle head unit, a notebook computer, a laptop, a tablet, a personal media player (PMP), or a personal digital assistant (PDA).

Other aspects, features, and advantages of the disclosure will become more apparent from the detailed description, the claims, and the drawings.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a plan view schematically illustrating a portion of a display apparatus, according to an embodiment of the present disclosure;
FIG. 2 is a cross-sectional view schematically illustrating a portion A of FIG. 1 according to an embodiment of the present disclosure;
FIG. 3 is a cross-sectional view schematically illustrating a state during a process of manufacturing the display apparatus of FIG. 1 according to an embodiment of the present disclosure; and
FIG. 4 is a cross-sectional view schematically illustrating a portion of a display apparatus according to an embodiment of the present disclosure.

### DETAILED DESCRIPTION OF EMBODIMENTS

Reference will now be made in detail to non-limiting embodiments, examples of which are illustrated in the accompanying drawings, wherein like reference numerals refer to like elements throughout. In this regard, the present embodiments may have different forms and should not be construed as being limited to the descriptions set forth herein. Accordingly, embodiments are merely described below, by referring to the figures, to explain aspects of the present disclosure. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the disclosure allows for various changes and numerous embodiments, certain embodiments will be illustrated in the drawings and described in the detailed description. Effects and features of the present disclosure, and methods for achieving them will be clarified with reference to embodiments described below in detail with reference to the drawings. However, the present disclosure is not limited to the described embodiments and may be embodied in various forms.

Hereinafter, embodiments will be described in detail with reference to the accompanying drawings, wherein the same or corresponding elements are denoted by the same reference numerals throughout and a repeated description thereof is omitted.

It will be understood that when a component, such as a layer, a film, a region, or a plate, is referred to as being "on" another component, the component may be directly on the other component or intervening components may be present therebetween. When a component, such as a layer, a film, a region, or a plate, is referred to as being "directly on" another component, no intervening components may be present therebetween. Also, sizes of components in the drawings may be exaggerated or reduced for convenience of explanation. For example, because sizes and thicknesses of components in the drawings may be arbitrarily illustrated for convenience of explanation, embodiments of the present disclosure are not necessarily limited thereto.

In the following embodiments, the x-axis, the y-axis and the z-axis are not necessarily limited to three axes of the rectangular coordinate system, and may be interpreted in a broader sense. For example, the x-axis, the y-axis, and the z-axis may be perpendicular to one another, or may represent different directions that cross each other and are not perpendicular to one another.

Although the terms "first," "second," etc. may be used to describe various elements, these elements should not be limited by these terms. These terms are only used to distinguish one element from another.

It will be further understood that the terms "comprises" or "comprising" used herein specify the presence of stated features or components, but do not preclude the presence or addition of one or more other features or components.

"A and/or B" is used herein to select only A, select only B, or select both A and B. "At least one of A and B" is used to select only A, select only B, or select both A and B.

It will be understood that when a layer, region, or component is referred to as being "connected," the layer, the region, or the component may be directly connected or may be indirectly connected with intervening layers, regions, or components therebetween. For example, when layers, regions, or components are referred to as being "electrically connected," the layers, the regions, or the components may be directly electrically connected, or may be indirectly electrically connected with intervening layers, regions, or components therebetween.

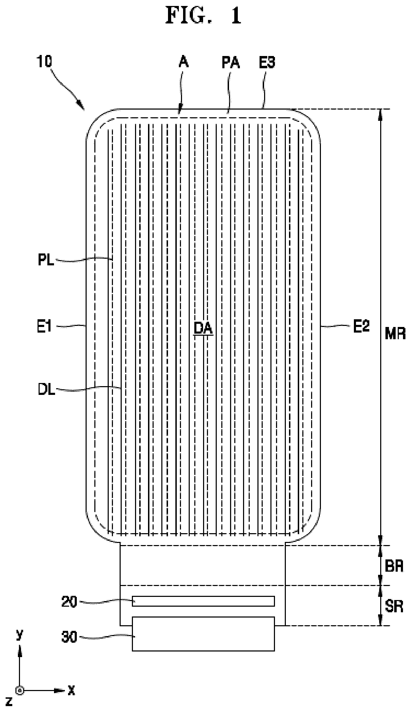

FIG. 1 is a plan view schematically illustrating a portion of a display apparatus, according to an embodiment. The display apparatus according to an embodiment includes a display panel 10. The display apparatus may be any electronic apparatus including the display panel 10 or the display apparatus. For example, in an embodiment the display apparatus may be any of various electronic apparatuses such as a smartphone, a mobile phone, a smart watch, a navigation device, a game device, a notebook computer, a tablet, a laptop, a personal media player (PMP), a personal digital assistance (PDA), a vehicle head unit, or a television (TV). However, embodiments of the present disclosure are not necessarily limited thereto and the display apparatus may be various other small, medium or large-sized electronic apparatuses.

In an embodiment, the display panel 10 includes a display area DA and a peripheral area PA outside the display area DA (e.g. in an x-axis and/or y-axis direction). The display area DA is a portion of the display panel 10 where an image is displayed. A plurality of pixels may be located in the display area DA. In an embodiment, when viewed in a direction substantially perpendicular to the display panel 10, the display area DA may have any of various shapes such as a circular shape, an elliptical shape, a polygonal shape, or a shape of a specific figure (e.g., in a plane defined in the x-axis and y-axis directions). In an embodiment as shown in FIG. 1, the display area DA has a substantially rectangular shape with rounded corners.

The peripheral area PA may be located outside the display area DA. In an embodiment, a width of a portion of the peripheral area PA (e.g., in an x-axis direction) may be less than a width of the display area DA (e.g., in the x-axis direction). Through this structure, at least a portion of the peripheral area PA may be easily bent when necessary.

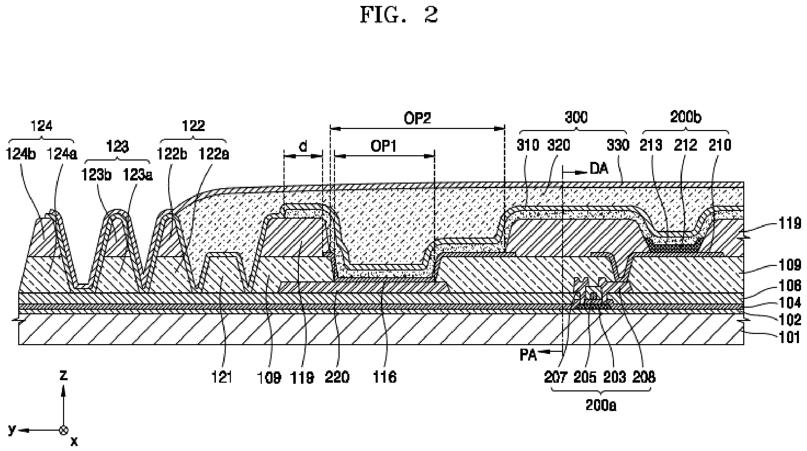

The display panel 10 includes a substrate 101 (see FIG. 2). In an embodiment, the substrate 101 may include the display area DA and the peripheral area PA. However, embodiments of the present disclosure are not necessarily limited thereto. For convenience, the following will be described assuming that the substrate 101 includes the display area DA and the peripheral area PA.

In an embodiment, a plurality of data lines DL may be located in the display area DA to cross the display area DA. Likewise, a plurality of power supply lines PL may be located in the display area DA to cross the display area DA. Although the data lines DL are marked by solid lines and the power supply lines PL are marked by dashed lines in FIG. 1 for convenience, in some embodiments the data lines DL and the power supply lines PL may be simultaneously formed on the same layer by using the same material.

Also, in some embodiments the display panel may include a main region MR, a bending region BR outside the main region MR, and a sub-region SR located opposite to the main region MR with the bending region BR therebetween. In the bending region BR, the display panel 10 may be bent so that at least a portion of the sub-region SR overlaps the main region MR when viewed in a z-axis direction. However, embodiments of the present disclosure are not necessarily limited to a bendable display apparatus, and the display panel 10 may also be applied to a non-bendable display apparatus in some embodiments. The sub-region SR may be a non-display area. As the display panel 10 is bent in the bending region BR, when the display apparatus is viewed from a front surface (e.g., in a -z direction), the non-display area may not be visible or even if it is visible, the visible area may be reduced.

A driving chip 20 may be located in the sub-region SR of the display panel 10. In an embodiment, the driving chip 20 may include an integrated circuit for driving the display panel 10. In an embodiment, the integrated circuit may be, but is not necessarily limited to, a data driving integrated circuit that generates a data signal.

The driving chip 20 may be mounted in the sub-region SR of the display panel 10. Although the driving chip 20 is mounted on the same surface as a display surface of the display area DA, as the display panel 10 is bent in the bending region BR as described above, the driving chip 20 may be disposed on a rear surface of the main region MR.

In an embodiment, a printed circuit board 30 or the like may be attached to an end of the sub-region SR of the display panel 10. In an embodiment, the printed circuit board 30 or the like may be electrically connected to the driving chip 20 through a plurality of pads arranged along one edge of the substrate.

Hereinafter, although an organic light-emitting display apparatus is described as a display apparatus according to an embodiment, the display apparatus of embodiments of the present disclosure are not necessarily limited thereto. For example, in some embodiments of the present disclosure, the display apparatus may be an inorganic light-emitting display apparatus or an inorganic electroluminescent (EL) display apparatus, or a quantum dot light-emitting display apparatus. For example, an emission layer of a display device included in the display apparatus may include an organic material or an inorganic material. Also, the display apparatus may include an emission layer and a quantum dot layer located in a path of light emitted from the emission layer.

As described above, the display panel 10 includes the substrate 101. Various elements included in the display panel 10 may be disposed on the substrate 101. In an embodiment, the substrate 101 may include glass, a metal, or a polymer resin. In an embodiment in which the display panel 10 is bendable in the bending region BR as described above, the substrate 101 needs to be flexible or bendable. In this embodiment, the substrate 101 may include a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate.

A plurality of pixels are located in the display area DA. Each of the pixels refers to a sub-pixel and may include a display device such as an organic light-emitting diode (OLED). In an embodiment, each pixel may emit, for example, red light, green light, blue light, or white light. However, embodiments of the present disclosure are not necessarily limited thereto and the pixels may emit a variety of different colors.

Each pixel may be electrically connected to outer circuits located in the peripheral area PA. For example, in an embodiment a scan driving circuit, an emission control driving circuit, a pad, a power supply line, and a common voltage supply line 220 (see FIG. 2) may be located in the peripheral area PA. The scan driving circuit may provide a scan signal to a pixel through a scan line. The emission control driving circuit may provide an emission control signal to a pixel through an emission control line. In an embodiment, the pad located in the peripheral area PA of the substrate 101 may be exposed without being covered by an insulating layer and may be electrically connected to the printed circuit board 30. A terminal of the printed circuit board 30 may be electrically connected to the pad of the display panel 10.

In an embodiment, the printed circuit board 30 transmits a signal or power of a controller to the display panel 10. For example, a control signal generated by the controller may be transmitted to the driving circuits through the printed circuit board 30. Also, the controller may transmit a first power supply voltage to a power supply line and may provide a second power supply voltage to the common voltage supply line 220. The first power supply voltage (e.g., ELVDD or driving voltage) may be transmitted to each pixel through the power supply line PL connected to the power supply line, and the second power supply voltage (e.g., ELVSS or common voltage) may be transmitted to a common electrode 213 (see FIG. 2) of a pixel connected to the common voltage supply line 220. In an embodiment, the common voltage supply line 220 may have a loop shape in which one side where the driving chip 20, etc. are located is open, to partially surround the display area DA. For example, in an embodiment the common voltage supply line 220 may have a shape extending along a first edge E1, a third edge E3, and a second edge E2 of the display panel 10 and partially surrounding the display area DA. A protective conductive layer 116 described below may also have this shape.

The controller may generate a data signal, and the generated data signal may be transmitted to a pixel through the driving chip 20 and the data line DL.

For reference, the term "line" may refer to a "wiring". This applies to the following embodiments and modifications thereof.

FIG. 2 is a cross-sectional view schematically illustrating a portion A of FIG. 1 As described above, the display panel 10 may include the bending region BR and the sub-region SR outside the main region MR. The display panel 10 may include the first edge E1 and the second edge E2 which are two edges extending away from the bending region BR and the sub-region SR (e.g., in the +y direction), and may include the third edge E3 located in a direction (e.g., the +y direction) opposite to the bending region BR with the display area DA therebetween and extending in a direction (e.g., the +x direction) connecting the first edge E1 to the second edge E2. The portion A may be a portion located near the third edge E3 and including the display area DA and the peripheral area PA.

A buffer layer 102 may be disposed on the substrate 101 (e.g., disposed directly thereon in the z direction). The buffer layer 102 may planarize a top surface of the substrate 101 and may prevent impurities such as oxygen or moisture penetrating from the outside through the substrate 101. In an embodiment, the buffer layer 102 may include an inorganic insulating material such as silicon oxide, silicon nitride, silicon oxynitride, aluminum oxide, aluminum nitride, titanium oxide, titanium nitride, tantalum oxide, hafnium oxide, or zirconium oxide, or an organic insulating material such as polyimide, polyester, or acryl. The buffer layer 102 may have a single-layer structure or a multi-layer structure. The buffer layer 102 may be located not only in the display area DA but also in the peripheral area PA. In an embodiment, the buffer layer 102 may be integrally formed in the display area DA and the peripheral area PA.

In an embodiment, a thin-film transistor 200a and an organic light-emitting element 200b electrically connected to the thin-film transistor 200a may be located in the display area DA.

In an embodiment, the thin-film transistor 200a may include an active layer 203, a gate electrode 205, a source electrode 207, and a drain electrode 208. The following will be described assuming that the thin-film transistor 200a is a top-gate type transistor in which the active layer 203, the gate electrode 205, the source electrode 207, and the drain electrode 208 are sequentially formed. However, embodiments of the present disclosure are not necessarily limited thereto, and the display apparatus may include any of various types of thin-film transistors 200a such as a bottom-gate type transistor, etc.

The active layer 203 may be disposed on the buffer layer 102 (e.g., disposed directly thereon in the z direction). In an embodiment, the active layer 203 may include a semiconductor material, for example, amorphous silicon or polycrystalline silicon. However, embodiments of the present disclosure are not necessarily limited thereto, and the active layer 203 may include various materials. For example, the active layer 203 may include an organic semiconductor material or may include an oxide semiconductor material. In an embodiment, the oxide semiconductor material may be, for example, an oxide of a material selected from metal elements of groups 12, 13, and 14 such as zinc (Zn), indium (In), gallium (Ga), tin (Sn), cadmium (Cd), and germanium (Ge) and a combination thereof.

A gate insulating film 104 may cover the active layer 203. In an embodiment, the gate insulating film 104 may include an inorganic insulating material such as silicon oxide, silicon nitride, silicon oxynitride, aluminum oxide, aluminum nitride, titanium oxide, titanium nitride, tantalum oxide, hafnium oxide, or zirconium oxide. The gate insulating film 104 may have a single-layer structure or a multi-layer structure. The gate insulating film 104 may insulate the active layer 203 from the gate electrode 205. The gate insulating film 104 may extend not only to the display area DA but also to at least a portion of the peripheral area PA.

The gate electrode 205 may be disposed on the gate insulating film 104 (e.g., disposed directly thereon in the z direction). In an embodiment, the gate electrode 205 may be electrically connected to a gate line that applies an on/off signal to the thin-film transistor 200a. For example, the gate electrode 205 is a portion of the gate line overlapping the active layer 203 when viewed in a direction perpendicular to the z axis (e.g., in a plan view).

The gate electrode 205 may include a metal material. In an embodiment, in considering adhesion to an adjacent layer, surface flatness of a stacked layer, and processability, the gate electrode 205 may include, for example, aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), or copper (Cu). However, embodiments of the present disclosure are not necessarily limited thereto. The gate electrode 205 may have a single-layer structure or a multi-layer structure. For example, in an embodiment the gate electrode 205 may have a three-layer structure such as a structure including a molybdenum layer, an aluminum layer, and a molybdenum layer.

An interlayer insulating film 106 may cover the gate electrode 205. The source electrode 207 and/or the drain electrode 208 may be disposed on the interlayer insulating film 106 (e.g., disposed directly thereon in the z direction). For example, the interlayer insulating film 106 may electrically insulate the source electrode 207 and the drain electrode 208 from the gate electrode 205. In an embodiment, the interlayer insulating film 106 may include an inorganic insulating material such as silicon oxide, silicon nitride, silicon oxynitride, aluminum oxide, aluminum nitride, titanium oxide, titanium nitride, tantalum oxide, hafnium oxide, or zirconium oxide. The interlayer insulating film 106 may have a single-layer structure or a multi-layer structure. The interlayer insulating film 106 may extend not only to the display area DA but also to at least a portion of the peripheral area PA.

The source electrode 207 and/or the drain electrode 208 may be disposed on the interlayer insulating film 106 (e.g., disposed directly thereon in the z direction). In an embodiment, the source electrode 207 and/or the drain electrode 208 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), or copper (Cu). The source electrode 207 and/or the drain electrode 208 may have a single-layer structure or a multi-layer structure. For example, in an embodiment the source electrode 207 and/or the drain electrode208 may have a three-layer structure such as a structure including a titanium layer, an aluminum layer, and a titanium layer.

Although the thin-film transistor 200a includes both the source electrode 207 and the drain electrode 208 in an embodiment shown in FIG. 2, embodiments of the present disclosure are not necessarily limited thereto. For example, in an embodiment one pixel circuit for controlling an operation of one organic light-emitting element 200b may include a plurality of thin-film transistors. In an embodiment, the active layer 203 included in a first thin-film transistor which is one thin-film transistor from among the plurality of thin-film transistors may be integrally formed with the active layer 203 included in a second thin-film transistor which is another thin-film transistor from among the plurality of thin-film transistors. In this embodiment, the first thin-film transistor may not include a drain electrode and the second thin-film transistor may not include a source electrode. For example, a drain region of the active layer 203 included in the first thin-film transistor and a source region of the active layer 203 included in the second thin-film transistor may be connected to or integrally formed with each other.

The source electrode 207 and/or the drain electrode 208 may be a portion of a signal line or a portion of a connection electrode. For example, in an embodiment the source electrode 207 and/or the drain electrode 208 may be a portion of the data line DL, or may be a portion of a connection electrode interposed between the data line DL and the active layer 203 to electrically connect the data line DL to the active layer 203. In this embodiment, the source electrode 207 and/or the drain electrode 208 may be a portion of a signal line or a connection electrode overlapping the active layer 203 when viewed in a direction of the z axis (e.g., in a plan view). In an embodiment, the source electrode 207 and/or the drain electrode 208 may directly contact the active layer 203 through a contact hole formed in the interlayer insulating film 106.

A planarization layer 109 may cover the thin-film transistor 200a. In an embodiment, the planarization layer 109 may have a substantially flat top surface despite the presence of the thin-film transistor 200a, etc. located under the planarization layer 109. In an embodiment, the planarization layer 109 may include an organic insulating material. For example, in an embodiment the planarization layer 109 may include bnzocyclobutene (BCB), polyimide, hexamethyldisiloxane (HMDSO), polymethylmethacrylate (PMMA), polystyrene, a polymer derivative having a phenol-based group, an acrylic polymer, an imide-based polymer, an aryl ether-based polymer, an amide-based polymer, a fluorinated polymer, a p-xylene-based polymer, a vinyl alcohol-based polymer, or a blend thereof.

At least one inorganic insulating layer including an inorganic insulating material may be interposed between the thin-film transistor 200a and the planarization layer 109. A connection electrode or a signal line may be interposed between the insulating layer and the planarization layer 109. In an embodiment in which insulating layers including an inorganic insulating material are interposed between the thin-film transistor 200a and the planarization layer 109, a connection electrode or a signal line may also be interposed between the insulating layers.

The organic light-emitting element 200b may be disposed on the planarization layer 109 (e.g., disposed directly thereon in the z direction). The organic light-emitting element 200b may include a pixel electrode 210, an intermediate layer 212 including an emission layer, and a counter electrode 213.

The pixel electrode 210 may be a (semi-)transmissive electrode or a reflective electrode. For example, in an embodiment, the pixel electrode 210 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof, and a transparent conductive layer disposed on the reflective layer. The transparent conductive layer may include at least one selected from the group consisting of indium tin oxide (ITO), indium zinc oxide (IZO), zinc oxide (ZnO or ZnO₂), indium oxide (In₂O₃), indium gallium oxide (IGO), and aluminum zinc oxide (AZO). For example, in an embodiment the pixel electrode 210 may have a three-layer structure including ITO/Ag/ITO.

A pixel-defining film 119 may be disposed on the planarization layer 109 (e.g., disposed directly thereon). For example, in an embodiment, the pixel-defining film 119 may cover lateral edges of the pixel electrode 210. The pixel-defining film 119 may have an opening defined to expose a central portion of the pixel electrode 210. The pixel-defining film 119 may increase a distance between an edge of the pixel electrode 210 and the counter electrode 213 over the pixel electrode 210 to prevent an arc or the like from occurring on the edge of the pixel electrode 210.

In an embodiment, the pixel-defining film 119 may be formed of at least one organic insulating material selected from the group consisting of polyimide, polyamide, an acrylic resin, benzocyclobutene, and a phenolic resin by using spin coating or the like.

At least a portion of the intermediate layer 212 of the organic light-emitting element 200b may be located in the opening defined in the pixel-defining film 119. An emission area of the organic light-emitting element 200b may be defined by the opening and may overlap the opening (e.g., in the z direction).

The intermediate layer 212 may include an emission layer. In an embodiment, the emission layer may include an organic material including a fluorescent or phosphorescent material that emits red, green, blue, or white light. The emission layer may be formed of a low molecular weight organic material or a high molecular weight organic material, and functional layers such as a hole transport layer (HTL), a hole injection layer (HIL), an electron transport layer (ETL), and an electron injection layer (EIL) may be selectively located under and over the emission layer.

The emission layer may be patterned to correspond to each of the pixel electrodes 210. However, embodiments of the present disclosure are not necessarily limited thereto and various modifications may be made to the intermediate layer 212. For example, in some embodiments layers other than the emission layer included in the intermediate layer 212 may be integrally formed over the plurality of pixel electrodes 210.

The counter electrode 213 may be a light-transmitting electrode or a reflective electrode. For example, in an embodiment the counter electrode 213 may be a transparent or semitransparent electrode and may include Li, Ca, LiF, Al, Ag, Mg, or a compound thereof. Also, the counter electrode 213 may further include a transparent conductive oxide (TCO) film such as ITO, IZO, ZnO, or ln₂O₃ disposed on a metal thin film. The counter electrode 213 may be integrally formed over the entire display area DA and may be disposed on the intermediate layer 212 and the pixel-defining film 127. For example, the counter electrodes 213 in the plurality of organic light-emitting elements 200b may be one electrode. In this regard, the counter electrode 213 may be referred to as a common electrode.

The organic light-emitting element 200b may be electrically connected to the thin-film transistor 200a. Although in an embodiment shown in FIG. 2, the pixel electrode 210 directly contacts the drain electrode 208 of the thin-film transistor 200a in FIG. 2, embodiments of the present disclosure are not necessarily limited thereto and various modifications may be made. For example, in an embodiment a connection electrode may be interposed between the pixel electrode 210 and the drain electrode 208 of the thin-film transistor 200a for electrical connection therebetween.

In an embodiment, the common voltage supply line 220 may be located in the peripheral area PA outside the display area DA. The common voltage supply line 220 may be electrically connected to the common electrode 213 to apply a second power supply voltage (e.g., ELVSS or common voltage) to the common electrode 213. In FIG. 2, the common voltage supply line 220 is disposed on (e.g., disposed directly thereon in the z direction) the interlayer insulating film 106, like the source electrode 207 and/or the drain electrode 208 of the thin-film transistor 200a. In this embodiment, the common voltage supply line 220 may be simultaneously formed of the same material as the source electrode 207 and/or the drain electrode 208 of the thin-film transistor 200a. However, embodiments of the present disclosure are not necessarily limited thereto. For example, in an embodiment the common voltage supply line 220 may be disposed on (e.g., disposed directly thereon in the z direction) the gate insulating film 104, like the gate electrode 205 of the thin-film transistor 200a. In this embodiment, the common voltage supply line 220 may be simultaneously formed of the same material as the gate electrode 205 of the thin-film transistor 200a. For convenience of explanation, the following will be described assuming that the common voltage supply line 220 is disposed on (e.g., disposed directly thereon in the z direction) the interlayer insulating film 106, like the source electrode 207 and/or the drain electrode 208 of the thin-film transistor 200a.

In FIG. 2, the common voltage supply line 220 is disposed only under the planarization layer 109. However, embodiments of the present disclosure are not necessarily limited thereto. For example, unlike in FIG. 2, in an embodiment the common voltage supply line 220 may further extend towards an edge of the substrate 101 (in the +y direction) to be located under at least one of dams 121, 122, 123, and 124.

Since the common voltage supply line 220 is electrically connected to the common electrode 213 as described above, the protective conductive layer 116 may be interposed between the common voltage supply line 220 and the common electrode 213 (e.g., in the z direction). For example, the protective conductive layer 116 may directly contact both the common voltage supply line 220 and the common electrode 213. For example, the common electrode 213 may extend from the display area DA to the peripheral area PA to directly contact the protective conductive layer 116 so that the common electrode 213 is electrically connected to the common voltage supply line 220.

As shown in FIG. 2, in an embodiment the protective conductive layer 116 may be disposed on (e.g., disposed directly thereon) the planarization layer 109, like the pixel electrode 210. In this embodiment, the protective conductive layer 116 and the pixel electrode 210 may be simultaneously formed by using the same material, and thus, the protective conductive layer 116 and the pixel electrode 210 may have the same layer structure.

During a process of manufacturing a display apparatus, a process of forming various elements may be performed after the common voltage supply line 220 is formed and before the common electrode 213 is formed. In an embodiment in which there is no protective conductive layer 116, then, during this process, a top surface of the common voltage supply line 220 may be damaged or oxidized. If the top surface of the common voltage supply line 220 is damaged or oxidized, then an appropriate second power supply voltage (e.g., ELVSS or common voltage) may not be applied to the common electrode 213 through the common voltage supply line 220. Accordingly, by disposing the protective conductive layer 116 on the common voltage supply line 220 so that the protective conductive layer 116 directly contacts the top surface of the common voltage supply line 220, damage or oxidation of the top surface of the common voltage supply line 220 may be prevented or reduced.

As described above, in an embodiment the pixel electrode 210 may include a transparent conductive layer including a conductive oxide such as indium tin oxide (ITO), indium zinc oxide (IZO), zinc oxide (ZnO or ZnO₂), indium oxide (In₂O₃), indium gallium oxide (IGO), or aluminum zinc oxide (AZO). Accordingly, the protective conductive layer 116 may also include a transparent conductive layer including a conductive oxide. Hence, oxidation of a top surface of the protective conductive layer 116 during a process after the protective conductive layer 116 is formed may be prevented or reduced.

As shown in FIG. 2, the planarization layer 109 may partly cover the common voltage supply line 220 and may have a first opening OP1 defined to expose a portion of the top surface of the common voltage supply line 220. For convenience, the planarization layer 109 may be referred to as a first insulating layer, and the first insulating layer may include the first opening OP1. As described above, in an embodiment at least one insulating layer including an inorganic insulating material may be interposed between the thin-film transistor 200a and the planarization layer 109. In this embodiment, the at least one insulating layer and the planarization layer 109 may be collectively referred to as a first insulating layer, and the first insulating layer may include the first opening OP1. The protective conductive layer 116 may be disposed on the first insulating layer and may directly contact the top surface of the common voltage supply line 220 through the first opening OP1. For example, the protective conductive layer 116 may be disposed directly on the first insulating layer, and may directly contact and cover a portion of the top surface of the common voltage supply line 220 exposed through the first opening OP1.

For reference, although FIG. 2 is a cross-sectional view schematically illustrating the portion A of FIG. 1 and thus, a portion of the planarization layer 109 covering a portion of the common voltage supply line 220 towards the display area DA (e.g., in a -y direction) and a portion of the planarization layer 109 covering a portion of the common voltage supply line 220 towards an edge (e.g., the third edge E3) of the substrate 101 (in the +y direction) are spaced apart from each other, the portion of the planarization layer 109 covering the portion of the common voltage supply line 220 towards the display area DA (e.g., in the -y direction) and the portion of the planarization layer 109 covering the portion of the common voltage supply line 220 towards the edge of the substrate 101 (e.g., in the +y direction) may be integrally formed. For example, in a plan view, the first opening OP1 may surround most of the display area DA but may not completely surround a circumference of the display area DA.

Since the protective conductive layer 116 directly contacts the top surface of the common voltage supply line 220 as described above, damage or oxidation of the top surface of the common voltage supply line 220 may be effectively prevented or reduced. In an embodiment, the protective conductive layer 116 may cover the entire portion of the common voltage supply line 220 exposed through the first opening OP1 of the first insulating layer. Accordingly, an end of the protective conductive layer 116 towards the edge of the substrate 101 (in the +y direction) may be disposed on a top surface of the first insulating layer so that the protective conductive layer 116 reliably covers the portion of the common voltage supply line 220 exposed through the first opening OP1 of the first insulating layer.

As shown in FIG. 2, the pixel-defining film 119 may partly cover the protective conductive layer 116 and may have a second opening OP2 defined to expose a portion of a top surface of the protective conductive layer 116. For convenience, the pixel-defining film 119 may be referred to as a second insulating layer, and the second insulating layer may include the second opening OP2. The common electrode 213 may be disposed on (e.g., disposed directly thereon in the z direction) the second insulating layer and may directly contact the top surface of the protective conductive layer 116 through the second opening OP2. For example, the common electrode 213 may be disposed on (e.g., disposed directly thereon in the z direction) the second insulating layer, and may directly contact and cover an entirety of the portion of the top surface of the protective conductive layer 116 exposed through the second opening OP2.

A width of the second opening OP2 (e.g., length in the y direction) may be greater than a width of the first opening OP1 (e.g., length in the y direction). For example, in the cross-sectional view as shown in FIG. 2, a width of the second opening OP2 may be greater than a width of the first opening OP1. When viewed in a direction perpendicular to the substrate 101 (e.g., in the z axis direction), that is, in a plan view, the area of the second opening OP2 may be greater than the area of the first opening OP1. In addition, in a plan view, the first opening OP1 may overlap the second opening OP2. For example, in a plan view, the first opening OP1 may be inside the second opening OP2.

For reference, although FIG. 2 is a cross-sectional view schematically illustrating the portion A of FIG. 1 and thus, a portion of the pixel-defining film 119 covering a portion of the protective conductive layer 116 towards the display area DA (e.g., in the -y direction) and a portion of the pixel-defining film 119 covering a portion of the protective conductive layer 116 towards the edge of the substrate 101 (e.g., in the +y direction) are spaced apart from each other, the portion of the pixel-defining film 119 covering the portion of the protective conductive layer 116 towards the display area DA (e.g., in the -y direction) and the portion of the pixel-defining film 119 covering the portion of the protective conductive layer 116 towards the edge of the substrate 101 (e.g., in the +y direction) may be integrally formed. For example, in a plan view, the second opening OP2 may surround most of the display area DA but may not completely surround the circumference of the display area DA.

A sufficient contact area between the protective conductive layer 116 and the common electrode 213 should be provided to sufficiently transmit an electrical signal from the common voltage supply line 220 to the common electrode 213. In an embodiment, the common electrode 213 may cover the entire portion of the protective conductive layer 116 exposed through the second opening OP2 of the second insulating layer. Accordingly, an end of the common electrode 213 towards the edge of the substrate 101 (in the +y direction), such as the third edge E3, may be disposed on a top surface of the second insulating layer so that the common electrode 213 reliably covers the entire portion of the protective conductive layer 116 exposed through the second opening OP2 of the second insulating layer.

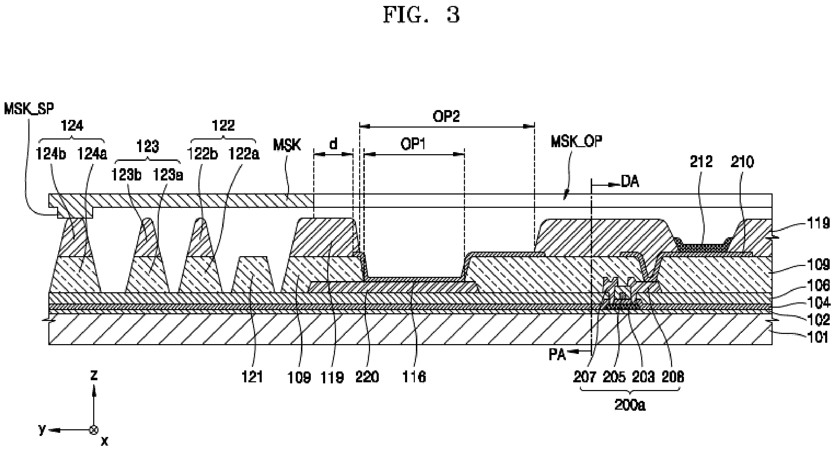

As shown in FIG. 2, the end of the common electrode 213 towards (e.g., adjacent to) the edge of the substrate 101 (e.g., in the +y direction) may be closer to the edge of the substrate 101 (e.g., the third edge E3) than the end of the protective conductive layer 116 towards (e.g., adjacent to) the edge (e.g., the third edge E3) of the substrate 101 (e.g., in the +y direction). This arrangement prevents or reduces defects from occurring during a manufacturing process, which will be described with reference to FIG. 3. While the orientation of the ends of the common electrode 213 and the protective conductive layer 116 are described with respect to the third edge E3 (e.g., in the +y direction), embodiments of the present disclosure are not necessarily limited thereto and the ends of the common electrode 213 and the protective conductive layer 116 may be similarly arranged with respect to other edges of the substrate 101 in some embodiments, such as the first edge E1 in the - x direction, the second edge E2 in the +x direction, etc.

FIG. 3 is a cross-sectional view schematically illustrating a state during a process of manufacturing the display apparatus of FIG. 1. In detail, FIG. 3 is a cross-sectional view schematically illustrating a process of forming the common electrode 213 after the intermediate layer 212 is formed on the pixel electrode 210. As shown in FIG. 3, to form the common electrode 213, a mask MSK is disposed on the pixel-defining film 119. The mask MSK has an opening MSK_OP corresponding to a portion where the common electrode 213 is to be formed. In an embodiment, the common electrode 213 as shown in FIG. 2 may be formed by disposing a material for forming the common electrode 213 on the intermediate layer 212 and the pixel-defining film 119 through the opening MSK_OP of the mask MSK by using a method such as sputtering or deposition. In an embodiment, the mask MSK may include a conductive material. For example, in an embodiment the mask MSK may include invar that is an alloy of iron.

In the manufacturing process, charges may be accumulated on the common voltage supply line 220 formed before the common electrode 213 is formed, due to friction or the like. Since the protective conductive layer 116 directly contacts the common voltage supply line 220, the electric potential of the protective conductive layer 116 is the same as the electric potential of the common voltage supply line 220. Accordingly, if the mask MSK including a conductive material is disposed to form the common electrode 213 and if a distance between a portion of the mask MSK other than the opening MSK_OP and the protective conductive layer 116 is relatively short, then a portion of the pixel-defining film 119 interposed between the portion of the mask MSK other than the opening MSK_OP and the protective conductive layer 116 may be damaged due to an electrical potential difference between the portion of the mask MSK other than the opening MSK_OP and the protective conductive layer 116. For example, since the pixel-defining film 119 is an insulating layer that may be a dielectric, dielectric breakdown or the like may occur in the portion of the pixel-defining film 119 between the portion of the mask MSK other than the opening MSK_OP and the protective conductive layer 116 due to an electrical potential difference between the portion of the mask MSK other than the opening MSK_OP and the protective conductive layer 116. For example, the portion of the pixel-defining film 119 may become ash (e.g., burnt) due to the dielectric breakdown. Accordingly, defects may occur in the common electrode 213 that is later formed, or impurities from the outside may move through the portion into the display area DA to cause defects in pixels.

To prevent these problems, when the display apparatus according to the present embodiment is manufactured, a sufficient distance is provided (e.g., in the y direction) between the portion of the mask MSK other than the opening MSK_OP and the protective conductive layer 116. In FIG. 3, a distance between the portion of the mask MSK other than the opening MSK_OP and the protective conductive layer 116 is increased by providing a distance "d" between the portion of the mask MSK other than the opening MSK_OP and the end of the protective conductive layer 116 towards the edge of the substrate 101 (e.g., in the +y direction in a plan view). Accordingly, dielectric breakdown or the like in the portion of the pixel-defining film 119 between the portion of the mask MSK other than the opening MSK_OP and the protective conductive layer 116 due to an electrical potential difference between the portion of the mask MSK other than the opening MSK_OP and the protective conductive layer 116 may be effectively prevented or reduced.

In an embodiment, the common electrode 213 is formed in a shape corresponding to the opening MSK_OP of the mask MSK. Accordingly, in the display apparatus manufactured through the above process, as shown in FIG. 2, the end of the common electrode 213 towards (e.g., adjacent to) the edge (e.g., the third edge E3) of the substrate 101 (e.g., in the +y direction) is closer to the edge of the substrate 101 than the end of the protective conductive layer 116 towards (e.g., adjacent to) the edge (e.g., the third edge E3) of the substrate 101 (e.g., in the +y direction).

In a comparative embodiment in which the end of the common electrode 213 towards the edge of the substrate 101 (e.g., in the +y direction) and the end of the protective conductive layer 116 towards the edge of the substrate 101 (e.g., in the +y direction) coincide with each other, or the end of the protective conductive layer 116 towards the edge of the substrate 101 (e.g., in the +y direction) is closer to the edge of the substrate 101 than the end of the common electrode 213 is towards the edge of the substrate 101 (e.g., in the +y direction), then during a manufacturing process, a distance between the portion of the mask MSK other than the opening MSK_OP and the protective conductive layer 116 may be too narrow. Accordingly, in this comparative embodiment, dielectric breakdown or the like may be very likely to occur in the portion of the pixel-defining film 119 interposed between the portion of the mask MSK other than the opening MSK_OP and the protective conductive layer 116 due to an electric potential difference between the portion of the mask MSK other than the opening MSK_OP and the protective conductive layer 116, and the rate of defects in the manufactured display apparatus may rapidly increase. However, the display apparatus according to an embodiment of the present disclosure may effectively prevent or reduce such defects.

In FIG. 2, the distance "d" between the end of the common electrode 213 towards (e.g., adjacent to) the edge of the substrate 101 (e.g., in the +y direction) and the end of the protective conductive layer 116 towards (e.g., adjacent to) the edge of the substrate 101 (e.g., in the +y direction) in a plan view may be in a range of about 300 µm to about 1000 µm. If the distance "d" is less than about 300 um, then a distance between the portion of the mask MSK other than the opening MSK_OP and the protective conductive layer 116 may be too short during the manufacturing process and thus the possibility of dielectric breakdown in the portion of the pixel-defining film 119 interposed between the portion of the mask MSK other than the opening MSK_OP and the protective conductive layer 116 may rapidly increase. If the distance "d" is greater than about 1000 µm, then the area of the first opening OP1 may be reduced to secure the distance "d". If the area of the first opening OP1 is reduced, this may reduce a contact area between the protective conductive layer 116 and the common voltage supply line 220, resistance may increase, and a defect such as the potential of the common electrode 213 being lower than the potential of the common voltage supply line 220 may occur. Accordingly, in an embodiment, the distance "d" between the end of the common electrode 213 towards the edge of the substrate 101 (e.g., in the +y direction) and the end of the protective conductive layer 116 towards the edge of the substrate 101 (e.g., in the +y direction) is in a range of about 300 µm to about 1000 µm.

As described above, the planarization layer 109 that may be referred to as a first insulating layer may cover the common voltage supply line 220 and may include the first opening OP1 through which a portion of a top surface of the common voltage supply line 220 is exposed. In an embodiment in which the protective conductive layer 116 covers the entire portion of the common voltage supply line 220 exposed through the first opening OP1 of the planarization layer 109, the end of the protective conductive layer 116 towards the edge of the substrate 101 (e.g., in the +y direction) may be disposed on a top surface of the planarization layer 109. Accordingly, when considering a portion of the top surface of the common voltage supply line 220 exposed through the first opening OP1 of the planarization layer 109, the end of the common electrode 213 towards (e.g., adjacent to) the edge of the substrate 101 (e.g., in the +y direction) may be closer to the edge of the substrate 101 (e.g., the third edge E3) than an end of the portion of the top surface of the common voltage supply line 220 towards (e.g., adjacent to) the edge (e.g., the third edge E3) of the substrate 101 (e.g., in the +y direction). Thus, the end of the common electrode 213 towards the edge of the substrate 101 (e.g., in the +y direction) is closer to the edge of the substrate 101 than an inner surface located towards the edge of the substrate 101 (e.g., in the +y direction) from among inner surfaces of the first opening OP1 of the planarization layer 109 that may be referred to as a first insulating layer.

As shown in FIG. 2, a thin-film encapsulation layer 300 may cover the organic light-emitting element 200b. In an embodiment, the thin-film encapsulation layer 300 may include at least one inorganic encapsulation layer and at least one organic encapsulation layer. For example, in an embodiment, the thin-film encapsulation layer 300 may include a first inorganic encapsulation layer 310, a second inorganic encapsulation layer 330, and an organic encapsulation layer 320 interposed between the first inorganic encapsulation layer 310 and the second inorganic encapsulation layer 330 (e.g., in the z direction).

In an embodiment, each of the first inorganic encapsulation layer 310 and the second inorganic encapsulation layer 330 may include at least one inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂), and may be formed by using chemical vapor deposition (CVD) or the like. The organic encapsulation layer 320 may include a polymer-based material. Examples of the polymer-based material may include a silicone-based resin, an acrylic resin (e.g., polymethyl methacrylate or polyacrylic acid), an epoxy resin, polyimide, and polyethylene. However, embodiments of the present disclosure are not necessarily limited thereto.

Each of the first inorganic encapsulation layer 310, the organic encapsulation layer 320, and the second inorganic encapsulation layer 330 may be integrally formed to cover the display area DA.

The dams 121, 122, 123, and 124 may be located in the peripheral area PA and may define a portion where a material for forming the organic encapsulation layer 320 of the thin-film encapsulation layer 300 is located when the organic encapsulation layer 320 of the thin-film encapsulation layer 300 is formed. The dams 121, 122, 123, and 124 may have a shape surrounding the display area DA in a plan view (e.g., in the x and/or y directions). The dams 121, 122, 123, and 124 may be spaced apart from each other in a plan view (e.g., in the x and/or y directions).

The dams 121, 122, 123, and 124 may have various layer structures. For example, the dam 121 may have a single-layer structure, and each of the dams 122, 123, and 124 may have a multi-layer structure. In FIG. 2, each of the dams 121, 122, 123, and 124 has a two-layer structure. Lower layers 122a, 123a, and 124a of the dams 122, 123, and 124 and the dam 121 may include, for example, the same material and the same layer structure as the planarization layer 109. In an embodiment, during the process of manufacturing the display apparatus, the lower layers 122a, 123a, and 124a of the dams 122, 123, and 124, the dam 121, and the planarization layer 109 are formed simultaneously by using the same material. Likewise, upper layers 122b, 123b, and 124b of the dams 122, 123, and 124 may include the same material and may have the same layer structure as the pixel-defining film 119. In an embodiment, during the process of manufacturing the display apparatus, the upper layers 122b, 123b, and 124b of the dams 122, 123, and 124 and the pixel-defining film 119 are simultaneously formed by using the same material.

The first inorganic encapsulation layer 310 of the thin-film encapsulation layer 300 may cover the display area DA and may extend outwardly to the peripheral area PA to cover up to at least a portion of the dam 124 that is an outermost dam. The organic encapsulation layer 320 of the thin-film encapsulation layer 300 may cover the display area DA and may extend to the peripheral area PA. However, the area of the organic encapsulation layer 320 may be defined by the dam 122. The second inorganic encapsulation layer 330 of the thin-film encapsulation layer 300 may cover the display area DA, and may extend to the peripheral area PA to directly contact the first inorganic encapsulation layer 310 outside the organic encapsulation layer 320. In FIG. 2, the second inorganic encapsulation layer 330 extends to at least a portion of the dam 124 that is an outermost dam.

For reference, as shown in FIG. 3, the mask MASK may have a support portion MSK_SP in addition to the opening MSK_OP. The support portion MSK_SP may be a portion disposed on an outer side of the mask MSK and protruding downwardly (e.g., in the -z direction). In an embodiment, when the mask MSK for forming the common electrode 213 is disposed on the substrate 101, the support portion MSK_SP of the mask MSK may directly contact a top surface of any one of the dams 122, 123, and 124 to maintain a distance (e.g., in the z direction) between the mask MSK and the substrate 101 substantially constant.

The display apparatus described above may be described as follows. When viewed in the direction perpendicular to the substrate 101 (e.g., in the z axis direction), the area of a portion of the common electrode 213 overlapping the common voltage supply line 220 may be greater than the area of a portion of the protective conductive layer 116 overlapping the common voltage supply line 220. This is a result of the end of the common electrode 213 towards the edge of the substrate 101 (e.g., in the +y direction) being closer to the edge of the substrate 101 than the end of the protective conductive layer 116 towards the edge of the substrate 101 (e.g., in the +y direction). For reference, the end of the common voltage supply line 220 towards the edge of the substrate 101 (in the +y direction) may be closer to the edge of the substrate 101 than the end of the protective conductive layer 116 towards the edge of the substrate 101. Accordingly, the resistance of the common voltage supply line 220 may be reduced by securing a sufficient area of the common voltage supply line 220.

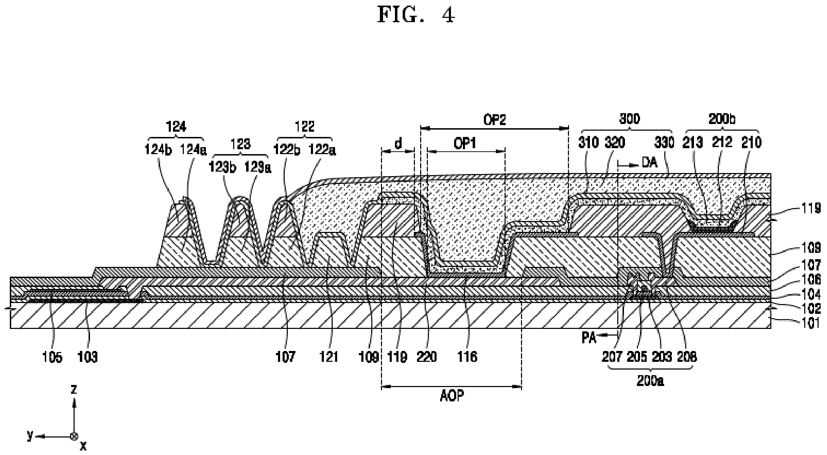

FIG. 4 is a cross-sectional view schematically illustrating a portion of a display apparatus, according to an embodiment. As shown in FIG. 4, the display apparatus according to an embodiment may further include a protective insulating layer 107 interposed between (e.g., disposed directly therebetween) the thin-film transistor 200a and the planarization layer 109 (e.g., in the z direction). The protective insulating layer 107 may protect the thin-film transistor 200a formed under the protective insulating layer 107 during a process of manufacturing a display apparatus, and may protect the thin-film transistor 200a by preventing impurities such as outgas generated from an element including an organic material located over the completed display apparatus from moving to the thin-film transistor 200a located under the protective insulating layer 107.

The protective insulating layer 107 may have an additional opening AOP as shown in FIG. 4. The additional opening AOP may expose a portion of a top surface of the common voltage supply line 220. For example, a portion of the top surface of the common voltage supply line 220 may be exposed through the additional opening AOP of the protective insulating layer 107. The exposed portion of the common voltage supply line 220 may also be exposed through the first opening OP1 of the planarization layer 109 on the protective insulating layer 107, and the protective conductive layer 116 may directly contact the exposed portion of the top surface of the common voltage supply line 220 exposed through the first opening OP1 of the planarization layer 109.

When viewed in the direction perpendicular to the substrate 101 (e.g., in the z axis direction) and when considering a portion of the top surface of the common voltage supply line 220 exposed through the additional opening AOP, an end of the common electrode 213 towards the edge of the substrate 101 (e.g., in the +y direction) may coincide with an end of the portion of the top surface of the common voltage supply line 220 towards the edge of the substrate 101. Thus, the end of the common electrode 213 towards (e.g., adjacent to) the edge of the substrate 101 (in the +y direction) may coincide with an inner surface towards (e.g., adjacent to) the edge of the substrate 101 (e.g., in the +y direction) from among inner surfaces of the additional opening AOP of the protective insulating layer 107.

As shown in FIG. 4, the area of the additional opening AOP of the protective insulating layer 107 in a plan view (e.g., in a plane defined in the x and y directions) may be greater than the area of the first opening OP1 of the planarization layer 109 in the plan view. Furthermore, when viewed in the direction perpendicular to the substrate 101 (e.g., in the z axis direction), the first opening OP1 of the planarization layer 109 may be located in the additional opening AOP of the protective insulating layer 107. Accordingly, the area of the top surface of the common voltage supply line 220 exposed through the first opening OP1 of the planarization layer 109 may be sufficiently secured.

As shown in FIG. 4, the common voltage supply line 220 may be electrically connected to a first transmission line 103 and/or a second transmission line 105 located adjacent to the edge of the substrate 101. The first transmission line 103 may be interposed between the substrate 101 and the buffer layer 102 (e.g., in the z direction). The second transmission line 105 may be interposed between the gate insulating film 104 and the interlayer insulating film 106 (e.g., in the z direction). In an embodiment, the second transmission line 105 and the gate electrode 205 may be simultaneously formed by using the same material. Accordingly, the second transmission line 105 and the gate electrode 205 may have the same layer structure. In an embodiment, the common voltage supply line 220 may be electrically connected to the second transmission line 105 through a contact hole formed in the interlayer insulating film 106, and may be electrically connected to the first transmission line 103 through a contact hole formed in the buffer layer 102, the gate insulating film 104, and the interlayer insulating film 106.

The first transmission line 103 and/or the second transmission line 105 may have a shape extending along the edge of the substrate 101 in the peripheral area PA. In an embodiment, the first transmission line 103 and the second transmission line 105 may transmit a common voltage to the common voltage supply line 220.

According to an embodiment as described above, a display apparatus that may prevent or reduce defects from occurring during a manufacturing process and an electronic apparatus including the display apparatus may be provided. However, the scope of embodiments of the present disclosure is not limited by this effect.

It should be understood that embodiments described herein should be considered in a descriptive sense only and not for purposes of limitation. Descriptions of features or aspects within each embodiment should typically be considered as available for other similar features or aspects in embodiments. While one or more embodiments have been described with reference to the figures, it will be understood by one of ordinary skill in the art that various changes in form and details may be made therein without departing from the scope of the present disclosure.

## Claims

1. A display apparatus comprising:
a substrate (101) comprising a display area and a peripheral area outside the display area;
a common voltage supply line (220) located in the peripheral area;
a protective conductive layer (116) directly contacting the common voltage supply line (220); and
a common electrode (213) extending from the display area to the peripheral area and directly contacting the protective conductive layer (116),
wherein an end of the common electrode (213) adjacent to an edge of the substrate (101) is closer to the edge of the substrate (101) than an end of the protective conductive layer (116) adjacent to the edge of the substrate (101).

2. The display apparatus of claim 1, wherein the protective conductive layer (116) directly contacts a top surface of the common voltage supply line (220).

3. The display apparatus of claim 1 or 2, further comprising:
a first insulating layer (109) covering the common voltage supply line (220), the first insulating layer comprising a first opening (OP1) exposing a portion of the top surface of the common voltage supply line (220),
wherein the protective conductive layer (116) is disposed on the first insulating layer and directly contacts the common voltage supply line (220) through the first opening.

4. The display apparatus of any of the preceding claims, wherein the common electrode (213) directly contacts a top surface of the protective conductive layer (116).

5. The display apparatus of claim 3, wherein the end of the protective conductive layer (116) is disposed on a top surface of the first insulating layer (109).

6. The display apparatus of any of the preceding claims, further comprising:
a second insulating layer (119) covering the protective conductive layer (116), the second insulating layer comprising a second opening (OP2) exposing a portion of a top surface of the protective conductive layer (116),
wherein the common electrode (213) is disposed on the second insulating layer and directly contacts the protective conductive layer (116) through the second opening.

7. The display apparatus of claim 6, wherein the end of the common electrode (213) is disposed on a top surface of the second insulating layer (119).

8. The display apparatus of any of claims 3 to 7, wherein:
the end of the common electrode (213) is closer to the edge of the substrate (101) than an end of a portion of the top surface of the common voltage supply line (220) adjacent to the edge of the substrate (101) that is exposed through the first opening (OP1).

9. The display apparatus of any of claims 3 to 8, further comprising:
a protective insulating layer (107) interposed between the common voltage supply line (220) and the first insulating layer, the protective insulating layer (107) comprising an additional opening (AOP) exposing a portion of the top surface of the common voltage supply line (220),
wherein, when viewed in a direction perpendicular to the substrate (101), the end of the common electrode (213) coincides with an end of the portion of the top surface of the common voltage supply line (220) that is exposed through the additional opening.

10. The display apparatus of claim 9, wherein an area of the additional opening in a plan view is greater than an area of the first opening in the plan view, and/or wherein, when viewed in the direction perpendicular to the substrate (101), the first opening is inside the additional opening.

11. The display apparatus of any of the preceding claims, further comprising a pixel electrode (210) located in the display area, wherein the protective conductive layer (116) and the pixel electrode (210) comprise a same material as each other.

12. The display apparatus of claim 11, wherein each of the protective conductive layer (116) and the pixel electrode (210) comprises a transparent conductive layer, and/or, wherein the pixel electrode (210) and the protective conductive layer (116) are disposed on a same layer as each other.

13. The display apparatus of any of the preceding claims, wherein a distance between the end of the common electrode (213) and the end of the protective conductive layer (116) is in a range of 300 µm to 1000 µm.

14. The display apparatus of any of the preceding claims, further comprising:
a dam (121, 122, 123, 124) located in the peripheral area and surrounding the display area; and
an inorganic encapsulation layer disposed on the common electrode (213) and extending outwardly from the common electrode (213) to the dam (121, 122, 123, 124).

15. The display apparatus of any of the preceding claims,
wherein when viewed in a direction perpendicular to the substrate (101), an area of a portion of the common electrode (213) overlapping the common voltage supply line (220) is greater than an area of a portion of the protective conductive layer (116) overlapping the common voltage supply line (220).

16. An electronic apparatus including the display apparatus of any of the preceding claims.

17. The electronic apparatus of claim 16, wherein the electronic apparatus is at least one of a smartphone, a mobile phone, a smart watch, a navigation device, a game device, a television (TV), a vehicle head unit, a notebook computer, a laptop, a tablet, a personal media player (PMP), or a personal digital assistant (PDA).
